# EUROPEAN PATENT SPECIFICATION

(11) **EP 1 160 995 B1**
(45) Date of publication and mention of the grant of the patent: **23.05.2012**
(21) Application number: 00111485.9
(22) Date of filing: 29.05.2000
(51) Int. Cl.: H03G 3/30, H04W 52/52

(54) **Mobile terminal for a wireless telecommunication system**
Mobiles Endgerät für drahtloses Telekommunikationssystem
Terminal mobile pour système de télécommunication sans fil

(43) Date of publication of application: 05.12.2001
(73) Proprietor: Sony Deutschland GmbH, 10785 Berlin (DE)
(72) Inventor: Rauch, Stefan, c/o Sony Int. (Europe) GmbH, 85609 Aschheim (DE)
(74) Representative: Körber, Martin Hans

(56) References cited:
- EP-A- 0 396 347
- GB-A- 2 286 315
- US-A- 5 287 555

## Description

The present invention relates to a mobile terminal for a wireless telecommunication system.

Conventional mobile terminals for a wireless telecommunication system, e.g. the GSM system, usually comprise a closed loop power control circuit for controlling the output power of a high-frequency transmit power amplifier. Controlling the output power of the power amplifier is necessary due to unavoidable frequency and temperature-dependant variations of the characteristics of the amplifier's components. To measure the actual output power of the power amplifier, it is known to probe the amplifier's output signal by means of a directional coupler and to detect its strength with a temperature-compensated detector diode. The directional coupler and the diode are RF components, their design is difficult and their chararcteristics are very sensitive to manufacturing tolerances. Therefore, they are fairly expensive.

As an alternative, it is known to detect the amplifier's supply current while operating the amplifier across a constant d.c. supply voltage. The current drawn by the amplifier is a measure for the amplifier's power consumption and hence for its output power, taking into account the amplifier's efficiency. Usually, a battery arrangement being part of a battery pack is used as a d.c. supply for the mobile terminal. Since the terminal voltage of batteries varies depending on the battery's charging state, age and temperature, a d.c./d.c. converter is used to keep the amplifier's supply voltage constant. In this solution, expensive RF components are not needed for power detection. Instead, a simple low-ohmic resistor can be used for current detection. However, a d.c./d.c. converter again is a complex component and considerably attributes to the costs of the whole power control circuit. Examples are provided in GB 2 286 315 and EP 396 347.

Therefore, it is an object of the present invention to provide a mobile terminal for a wireless telecommunication system having a power control circuit which is less complex and less expensive.

To achieve this object, the present invention provides a mobile terminal for a wireless telecommunication system as claimed in claim 1.

Variations of the supply voltage can influence the amplifier's output power level, even if the supply current is kept constant. That is, in case of the supply voltage not being constant it is no longer possible to deduce the actual value of the amplifier's output power solely from the supply current actually drawn by the amplifier. In the inventive solution, the actual value of the supply voltage is detected and taken into account when forming the manipulated signal. In this way, even a non-constant supply voltage can be applied to the amplifier, provided that the relationship between variations of the supply voltage and resulting variations of the amplifier's output power is known. This relationship can be established in advance by experiment or simulation, for example.

As a result, a d.c./d.c. converter for providing a constant supply voltage is not needed any longer in the inventive solution. In particular, the invention enables the power amplifier to be supplied directly from a battery arrangement of said terminal, without any voltage controlling means being interposed between the battery arrangement and the amplifier.

At first sight, one might think that the necessity of providing means for detecting the supply voltage would cancel the advantage that a d.c./d.c. converter can be omitted. However, this proves not to be true. First, a d.c. voltage detector can be realized much easier and at considerably lower costs than a d.c./d.c. converter. Secondly, in conventional mobile terminals, such a voltage detector typically is already present in the form of a voltage detector used for detecting the charging state of a supply battery. Thus, the inventive solution may be implemented without any substantial contructional modifications to existing mobile terminals, except for the removal of the d.c./d.c. converter.

According to a preferred embodiment of the invention, the power control circuit is arranged to vary the reference signal dependant on the actual value of the supply voltage. As an alternative, it is conceivable to realize a disturbance feedforward for taking into account supply voltage variations, though.

In the above preferred embodiment, the power control circuit advantageously includes memory means for storing digital data representing a set of voltage compensation values indicative of different actual values of the supply voltage, the power control circuit being arranged to offset the target value of the output power by one of the voltage compensation values selected according to the actual value of the supply voltage as detected by the voltage detection means and to convert the offset target value into an analog signal representing the reference signal.

Memory means and means for offsetting the target value of the output power are already present in many conventional mobile terminals for effecting a frequency and/or temperature-dependant offset of the power target value. The same applies to a digital-analogue converter for converting the offset target value into analogue. A conventional circuit design can therefore be adopted for the power control circuit without the necessity of substantial circuit modifications.

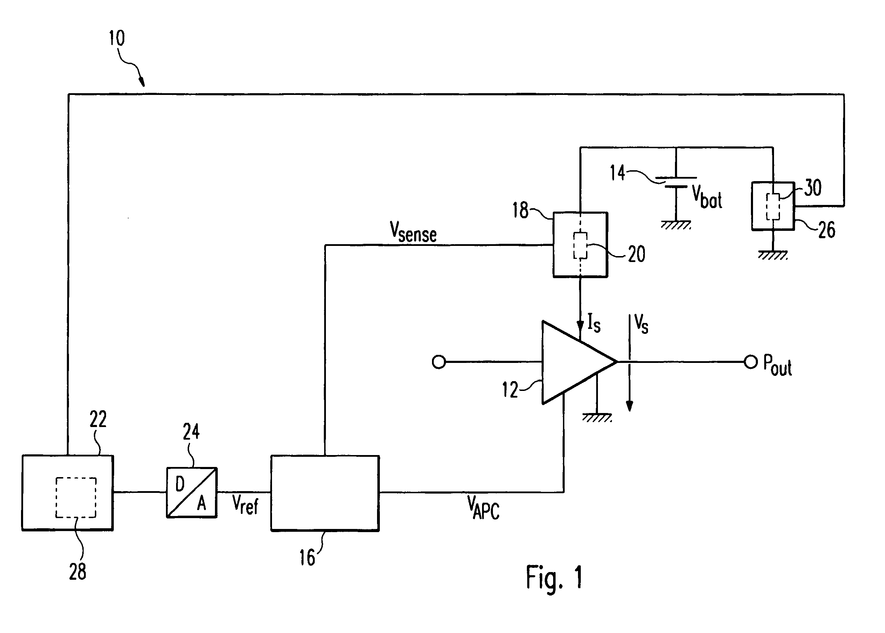

Next, an embodiment of the present invention will be explained in detail and by way of example only with reference to the attached single figure 1 showing a schematic block diagram of a power control circuit generally designated by 10.

The power control circuit 10 serves for controlling the power Pₒᵤₜ of an RF output signal of a transmit power amplifier 12 of a mobile terminal, e.g. a mobile telephone, for a wireless telecommunication system, e.g. according to the GSM or the UMTS standard. The power amplifier 12 receives a RF signal having a power Pᵢₙ and delivers the output signal to an antenna not shown for being transmitted therefrom. It is operated across a supply voltage Vₛ indicated by an arrow and directly supplied from a battery arrangement 14 inserted into the mobile terminal and draws a supply current I_{S} from the battery arrangement 14. The battery arrangement 14 is e.g. part of a battery pack of the mobile terminal.

The power control circuit 10 is designed as a closed loop control circuit. Its controlling member - designated by 16 - receives analogue signals Vₛₑₙₛₑ and V_{ref} and provides a signal V_{APC} to the power amplifier 12. Vₛₑₙₛₑ is a feedback variable of the power control circuit 10 and represents the actual value of the supply current I_{S} as detected by a current detector 18. For example, the current detector 18 may comprise a low-ohmic resistor 20 and detect, as the signal Vₛₑₙₛₑ, the voltage drop across resistor 20. V_{ref} is a signal representing a corrected target value of the output power Pₒᵤₜ. The controlling member 16 compares Vₛₑₙₛₑ and V_{ref} and generates V_{APC} based on the difference therebetween. V_{APC} represents a manipulated variable of the power control circuit 10 and is used for influencing the power amplifier 12 so as to obtain a desired value of the output power Pₒᵤₜ.

At constant values of the temperature, frequency and supply voltage Vₛ, the actual value of the supply current Iₛ is indicative of the output power Pₒᵤₜ. However, these parameters may change in value. In the embodiment shown, the supply voltage Vₛ is directly related to the terminal voltage V_{bat} of the battery arrangment 14. The terminal voltage V_{bat} is usually not constant over long periods, due to discharging of the battery arrangement 14 or temperature variations. Thus, the supply voltage Vₛ is not constant, too. Furthermore, as e.g. in GSM systems, the frequency of the amplifier's output signal may vary dependent on the channel used. At varying values of the temperature, frequency and supply voltage Vₛ, the actual value of the supply current Iₛ is no longer a true measure of the output power Pₒᵤₜ. As these parameters change in value, the actual value of the output power Pₒᵤₜ also changes, without a corresponding change of the supply current Iₛ. Therefore, the power control circuit 10 provides for a temperature, frequency and voltage compensation when forming the reference signal V_{ref}.

To generate the reference signal V_{ref}, the power control circuit 10 comprises a reference signal forming unit 22 to which a central control unit of the mobile terminal (not shown here in detail) instructs a target value of Pₒᵤₜ, e.g. 0,5 W, 1 W or 2 W. The target value of Pₒᵤₜ may vary according to output power settings instructed from a connected base station of the wireless telecommunication system. The reference signal forming unit 22 then corrects the instructed Pₒᵤₜ value by a voltage compensation value and/or a frequency compensation value and/or a temperature compensation value, if necessary. The compensation values are determined using one or a combination of the basic arithmetical operations (e.g. addition, substraction, multiplication, division, etc.). By applying these values to the target value of Pₒᵤₜ, the correction will be done. Thus, the corrected target value may be greater or smaller than the Pₒᵤₜ value as initially instructed. The reference signal forming unit 22 then outputs the corrected target value of Pₒᵤₜ to a digital-analogue converter 24 which converts the corrected target value of Pₒᵤₜ into the analogue reference signal V_{ref}.

For purpose of voltage compensation, a voltage detector 26 detects the actual value of V_{bat} and supplies it to the reference signal forming unit 22. The reference signal forming unit 22 includes a memory 28 (indicated by dashed lines) in which a set of voltage compensation values established by experiment or empiricism is stored. Depending on the actual value of V_{bat,} the reference signal forming unit 22 selects one of the voltage compensation values from the set and applies it to the instructed target value of Pₒᵤₜ. For example, if the actual value of V_{bat} corresponds to a nominal value of the terminal voltage of the battery arrangement 14, no correction of the target value of Pₒᵤₜ will be carried out (i.e. no voltage-compensation value is applied). If the actual value of V_{bat} is lower than the nominal value, a positive voltage compensation value is added to the target value of Pₒᵤₜ. This results in an increase in the corrected target value of Pₒᵤₜ compensating for a power drop due to a decreased supply voltage Vₛ. In this way, Pₒᵤₜ can be kept constant even when V_{bat} decreases over time. Since a decrease in V_{bat} occurs rather slowly, an update of the selected voltage-compensation value is required only in relatively long intervals.

As an alternative to the set of voltage compensation values stored in the memory 28, it is conceivable to establish a mathematical relationship between Vₛ (or V_{bat}) and Pₒᵤₜ and to calculate a required voltage compensation value from a suitable formula stored in the reference signal forming unit 22.

Furthermore, the voltage detector 26 may detect the actual value of Vₛ instead of V_{bat}. A simple high-ohmic resistor 30 in parallel connection to the battery arrangement 14 may be used as the voltage detector 26, for example.

To compensate for temperature and frequency variations, similar sets of temperature and frequency compensation values may be stored in the memory 28.

## Claims

1. Mobile terminal for a wireless telecommunication system, comprising:
a high-frequency transmit power amplifier (12) operated across a d.c. supply voltage (Vs);
**characterized in**
a closed loop power control circuit (10) for controlling an output power (Pₒᵤₜ) of said power amplifier (12), said power control circuit (10) comparing a reference signal (Vref) indicative of a target value of said output power (Pout) to a signal (Vsense) indicative of an actual value of said output power (Pout) and providing a manipulated signal (Vapc) to said power amplifier (12) to obtain a desired value of the output power (Pout), said power control circuit (10) including current detection means (18) for detecting said signal (Vsense) as a feedback variable of the power control circuit (10) representing said actual value of the supply current (Is) drawn by said power amplifier (12);
a controlling member (16), inside the power control circuit (10), adapted to receiving analog signals Vsense and Vref and providing a signal Vapc to the power amplifier (12) based on the difference between Vsense and Vref; and
a voltage detection means (26) for detecting a signal indicative of an actual value of said supply voltage (Vs or Vbat),
wherein said power control circuit (10) is responsive to said voltage detection means (26) and arranged to vary said manipulated signal (Vapc) dependent on said actual value of said supply voltage (Vs) as detected by said voltage detection means (26).

2. Mobile terminal according to claim 1,
**characterized in**
**that** said power amplifier (12) is supplied directly from a battery arrangement (14) of said terminal.

3. Mobile terminal according to claim 1 or 2,
**characterized in**
**that** said power control circuit (10) is arranged to vary said reference signal (Vref) dependent on said actual value of said supply voltage (Vₛ or Vbat).

4. Mobile terminal according to claim 3,
**characterized in**
**that** said power control circuit (10) includes memory means (28) for storing digital data representing a set of voltage compensation values indicative of different actual values of said supply voltage (Vs or Vbat), said power control circuit (10) being arranged to offset said target value of said output power (Pout) by one of said voltage compensation values selected according to said actual value of said supply voltage (Vₛ or Vbat) as detected by said voltage detection means (26) and to convert said offset target value into an analog signal representing said reference signal (Vref).

## Patentansprüche

1. Mobilgerät für ein tragloses Telekommunikationssystem, mit:
einem Hochfrequenz-Übertragungsleistungs-Verstärker (12), der über eine Gleichstrom-Versorgungsspannung (Vₛ) betrieben ist,
**gekennzeichnet durch**
Leistungsregelungsschaltung (10) zum steuern einer Ausgangsleistung (Pₒᵤₜ) des Leistungsverstärkers (12), wobei die Leistungsregelungsschaltung (10) eines einem Zielwert der Ausgangsleistung (Pₒᵤₜ) anzeigendes Referenzsignal (V_{ref)} mit einem tatsächlichen Wert der Ausgangsleistung (Pₒᵤₜ) anzeigendes Signal (Vₛₑₙₛₑ₎ vergleicht und ein bearbeitetes Signal (V_{APC}) dem Leistungsverstärker (12) bereitstellt, um einen gewünschten Wert der Ausgangsleistung (Pₒᵤₜ) zu erhalten, wobei die Leistungsregelungsschaltung (10) eine Stromerkennungseinrichtung (18) zum erkennen des Signales (Vₛₑₙₛₑ₎ als eine Rückkopplungsvariable der Leistungsregelungsschaltung (10) erkennt, die den tatsächlichen Wert des von dem Leistungsverstärker (12)gezogenen Versorgungsstroms (I_{S}) repräsentiert.
Eine Steuereinrichtung (16) innerhalb der Leistungsregelungsschaltung (10), die ausgelegt ist, analoge Signale (Vₛₑₙₛₑ und V_{ref}) zu empfangen und ein Signal (V_{APC}) dem Leistungsverstärker (12) auf der Basis des Unterschiedes zwischen Vₛₑₙₛₑ und V_{ref} bereitzustellen.
Eine Spannungserkennungseinrichtung (26) zum erkennen eines tatsächlichen Wert der Versorgungsspannung (Vₛ oder V_{bat}) anzeigenden Signals,
wobei die Leistungsregelungsschaltung (10) auf die Spannungserkennungseinrichtung (26) anspricht und ausgelegt ist, dass erarbeitetes Signal (V_{APC}) abhängig von dem tatsächlichen Wert der Versorgungsspannung (V_{S}), wie von der Spannungserkennungseinrichtung (26) erkannt, zu variieren.

2. Mobilgerät gemäß Anspruch 1,
**dadurch gekennzeichnet, dass** der Leistungsverstärker (12) direkt von einer Batterieanordnung (14) des Gerätes versorgt ist.

3. Mobilgerät gemäß Anspruch 1 oder 2,
**dadurch gekennzeichnet,**
**dass** die Leistungsregelungsschaltung (10) angeordnet ist, das Referenzsignal (V_{ref}) abhängig von dem tatsächlichen Wert der Versorgungsspannung (Vs oder V_{bat}) zu variieren.

4. Mobilgerät gemäß Anspruch 3,
**dadurch gekennzeichnet,**
**dass** die Leistungsregelungsschaltung (10) eine Speichereinrichtung (28) zum Speichern digitaler Daten umfasst, die einen Satz von Spannungskompensationswerten darstellen, verschiedene tatsächliche Werte der Versorgungsspannung (Vs oder V_{bat}) anzeigen, wobei die Leistungssteuerungsschaltung (10) ausgelegt ist, den Zielwert der Ausgangsleistung (Pₒᵤₜ) durch einen der Spannungskompensationswerte zu versetzten, die gemäß dem tatsächlichen Wert der Versorgungsspannung (V_{S} oder V_{bat}) ausgewählt sind, wie von der Spannungserkennungseinrichtung (26) detektiert, und den Umsetz-Zielwert in ein analoges Signal umzuwandeln, dass das Referenzsignal repräsentiert (V_{ref}).

## Revendications

1. Terminal mobile pour un système de télécommunication sans fil, comprenant :
un amplificateur de puissance de transmission à haute fréquence (12) commandé par une tension d'alimentation continue (Vs) ;
**caractérisé en ce que** :
un circuit de commande de puissance en boucle fermée (10) pour commander une puissance de sortie (Pout) dudit amplificateur de puissance (12), ledit circuit de commande de puissance (10) comparant un signal de référence (Vref) indicatif d'une valeur cible de ladite puissance de sortie (Pout) à un signal (Vsense) indicatif d'une valeur réelle de ladite puissance de sortie (Pout) et fournissant un signal manipulé (Vapc) audit amplificateur de puissance (12) pour obtenir une valeur souhaitée de la puissance de sortie (Pout), ledit circuit de commande de puissance (10) comprenant des moyens de détection de courant (18) pour détecter ledit signal (Vsense) en tant que variable de retour d'information du circuit de commande de puissance (10) représentant ladite valeur réelle du courant d'alimentation (Is) prélevé par ledit amplificateur de puissance (12) ;
un organe de commande (16), à l'intérieur du circuit de commande de puissance (10), adapté pour recevoir les signaux analogiques Vsense et Vref et pour fournir un signal Vapc à l'amplificateur de puissance (12) en fonction de la différence entre Vsense et Vref ; et
un moyen de détection de tension (26) pour détecter un signal indicatif d'une valeur réelle de ladite tension d'alimentation (Vs ou Vbat),
ledit circuit de commande de puissance (10) agissant en réponse audit moyen de détection de tension (26) et étant conçu pour faire varier ledit signal manipulé (Vapc) en fonction de ladite valeur réelle de ladite tension d'alimentation (Vs) telle que détectée par ledit moyen de détection de tension (26).

2. Terminal mobile selon la revendication 1,
**caractérisé en ce que**
ledit amplificateur de puissance (12) est alimenté directement par un arrangement de batterie (14) dudit terminal.

3. Terminal mobile selon la revendication 1 ou 2,
**caractérisé en ce que**
ledit circuit de commande de puissance (10) est conçu pour faire varier ledit signal de référence (Vref) en fonction de ladite valeur réelle de ladite tension d'alimentation (Vs ou Vbat).

4. Terminal mobile selon la revendication 3,
**caractérisé en ce que**
ledit circuit de commande de puissance (10) comprend des moyens de mémoire (28) pour stocker des données numériques représentant un ensemble de valeurs de compensation de tension indicatives de différentes valeurs réelles de ladite tension d'alimentation (Vs ou Vbat), ledit circuit de commande de puissance (10) étant conçu pour décaler ladite valeur cible de ladite puissance de sortie (Pout) de l'une desdites valeurs de compensation de tension, sélectionnée en fonction de ladite valeur réelle de ladite tension d'alimentation (Vs ou Vbat) telle que détectée par ledit moyen de détection de tension (26), et pour convertir ladite valeur cible décalée en un signal analogique représentant ledit signal de référence (Vref).
